(19) Europäisches Patentamt
European Patent Office
Office européen des brevets

(11) **EP 2 803 704 A2**

## (12) EUROPEAN PATENT APPLICATION

(43) Date of publication:
**19.11.2014 Bulletin 2014/47**

(51) Int Cl.:
**C09C 1/30** (2006.01)  **B22F 1/02** (2006.01)
**C09K 3/14** (2006.01)  **C01B 33/149** (2006.01)
**H01L 21/304** (2006.01)

(21) Application number: **14164676.0**

(22) Date of filing: **15.04.2014**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **19.04.2013 US 201361813950 P
25.03.2014 US 201414224839**

(71) Applicant: **AIR PRODUCTS AND CHEMICALS, INC.
Allentown, PA 18195-1501 (US)**

(72) Inventors:
• **Zhou, Hongjun**
  **Chandler, AZ Arizona 85248 (US)**
• **Shi, Xiaobo**
  **Chandler, AZ Arizona 85224 (US)**
• **Schleuter, James A.**
  **Phoenix, AZ Arizona 85045 (US)**
• **Schwartz, Jo-Ann T.**
  **Macungie, PA Pennsylvania 18062 (US)**

(74) Representative: **Beck Greener
Fulwood House
12 Fulwood Place
London WC1V 6HR (GB)**

(54) **Metal compound coated colloidal particles process for making and use therefor**

(57)     Solid metal compound coated colloidal particles are made through a process by coating metal compounds onto colloidal particle surfaces. More specifically, metal compound precursors react with the base solution to form solid metal compounds. The solid metal compounds are deposited onto the colloidal particle surfaces through bonding. Excess ions are removed by ultrafiltration to obtain the stable metal compound coated colloidal particle solutions. Chemical mechanical polishing (CMP) polishing compositions using the metal compound coated colloidal particles prepared by the process as the solid state catalyst, or as both catalyst and abrasive, provide uniform removal profiles across the whole wafer.

EP 2 803 704 A2

**Description**

BACKGROUND OF THE INVENTION

Present invention discloses metal compound coated colloidal particles, methods of making, and use therefor. The metal compound coated colloidal particles have an important role in the slurry for chemical mechanical polishing (CMP) applications. For example, they can be used as the catalyst in CMP slurry. The metal compound coated colloidal particles include, but are not limited to, metal ion, metal oxide coated colloidal particles.

There are a large number of materials used in the manufacture of integrated circuits such as a semiconductor wafer. The materials generally fall into three categories-dielectric material, adhesion and/or barrier layers, and conductive layers. The use of the various substrates, for instances, dielectric material such as TEOS (TEOS refers to Tetraethyl orthosilicate which is the precursor for making silicon dioxide films through chemical deposition process), plasma-enhanced TEOS (PETEOS), and low-k dielectric materials; barrier/adhesion layers such as tantalum, titanium, tantalum nitride, and titanium nitride; and conductive layers such as copper, aluminum, tungsten, and noble metals are known in the industry.

In semiconductor manufacturing process, metalized vias or contacts are formed. Typically, via holes are etched through the interlevel dielectric (ILD) to interconnection lines or to a semiconductor substrate. Next, a thin adhesion layer such as titanium nitride and/or titanium is generally formed over the ILD and is directed into the etched via hole. Then, a conducting film is blanket deposited over the adhesion layer and into the via. The deposition is continued until the via hole is filled with the conductive material. The excess conductive material is removed by chemical mechanical polishing (CMP) to form metal vias.

During the CMP process the chemicals present in CMP slurry develop an oxide layer onto the surface and this surface is mechanically abraded by abrasive particles. The CMP process must provide a high removal rate and good planarity through the simultaneous actions of chemical dissolution and mechanical abrasion.

In one particular semiconductor manufacturing process, via holes are etched through the interlevel dielectric (ILD) to interconnection lines or to a semiconductor substrate. Next, a thin adhesion layer such as titanium nitride and/or titanium is generally formed over the ILD and is directed into the etched via hole. Then, a tungsten film is blanket deposited over the adhesion layer and into the via. The deposition is continued until the via hole is filled with tungsten. Finally, the excess tungsten is removed by chemical mechanical polishing (CMP) to form metal vias.

A CMP slurry usually consists of abrasive, catalyst and oxidizer, and optionally a corrosion inhibitor. Work has been done in making various types of the catalyst.

US4478742 disclosed a method of producing iron acetate coated silica sol comprising the steps of passing a mixture of ion-free colloidal silica and an inorganic iron salt in contact with a strong base anion exchange resin in the acetic acid salt under conditions whereby the iron salt is converted to the iron acetate and is coated on the silica sol, thereby producing an iron acetate coated silica sol.

J. Colloid & Inter. Sci. 2010, 349, 402-407, taught a new method of Fe (metal) precipitation on colloidal silica with commercially available fumed silica slurry containing Fe ions, to overcome the stability problem (responsible in producing defects). The slurry was developed by using sodium silicate ($Na_2SiO_3$) as a raw material and the concentration of precipitation of metal was controlled by addition of Fe salt ($Fe(NO_3)_3$). To compare the concentration of precipitated Fe with directly added Fe ions in slurry solutions, static electrochemical and peroxide decomposition experiments were performed. Although the performance of the Fe precipitation appeared to be lower than Fe ion addition during these experiments, nearly equal removal rates were observed due to the dynamic condition during polishing.

J. Colloid & Inter. Sci. 2005, 282, 11-19, studied the synthesis and characterization of iron oxide-coated silica. A three-level fractional factorial study was used to determine the optimum conditions for producing goethite-coated silica. The amount of coating achieved was between 0.59 and 21.36 mg Fe $g^{-1}$ solid. The most significant factor in coating using either adsorption or precipitation was the particle size of silica, where Fe increased from an average of 0.85 to 9.6 mg Fe $g^{-1}$ solid as silica size decreased from 1.5 to 0.2 mm. Other factors investigated, including coating temperature, initial iron concentration, and contact time, were of less importance. The iron oxide coatings were observed to be nonuniform, concentrated in rough concave areas. FTIR revealed a band shift as well as a new band indicating changes in the chemical environment of Fe-O and Si-O bonds; these results along with abrasion studies suggest that the interaction between the oxide coating and silica surface potentially involves chemical forces. Because the nano-sized iron oxide coatings increased surface area, introduced small pores, and changed the surface charge distribution of silica, the coated system demonstrates a greater affinity for Ni compared to that of uncoated silica.

Tribology 2010, 30(3): 268-272A synthesized silicon/ferric oxide core-shell abrasive by using $HNO_3$, NaOH, Fe $(NO_3)_3$ and $SiO_2$ through chemical co-precipitation. The structure and dispersibility of the silicon/ferric oxide core-shell abrasive were characterized by X-ray diffraction (XRD), time-of-flight secondary ion mass spectroscopy (TOF-SIMS) and scanning electron microscope (SEM). The silicon/ferric oxide core-shell abrasive was then used to perform CMP of hard disk substrate.

US2013/0068995 discloses a silica having metal ions absorbed thereon and a fabricating method thereof. The method includes following steps. A solution is provided, and the solution includes silica and persulfate salt therein. The solution is heated to react the silica with the persulfate salt, so as to obtain silica modified with the persulfate salt. Metal compound source is added in the solution, the metal compound source dissociates metal ions, and the silica modified with persulfate salt absorbs the metal ions to obtain the silica having metal ions absorbed thereon.

A stable, well-dispersed solution is very critical for CMP slurry. A unstable or separated CMP slurry often contains a lot of aggregates or large particles, which cause defects on the film polished.

There is still a need for making solid metal compound coated colloidal particles in a simple, low cost way. The solid metal compound coated colloidal particles are needed in CMP process(es) and slurry(s) to provide high removal rate and good planarity.

BRIEF SUMMARY OF THE INVENTION

In one aspect, the invention provides particulates comprising:

solid metal compound coated colloidal particles formed by bonding metal compound particles on surfaces of colloidal particles; and
spaces among solid metal compound coated colloidal particles are free of the metal compound particles;

wherein
size of the metal compound particles ranging from 0.01-10 nm;
size of the colloidal particles ranging from 10-1000 nm; and
the size of the metal compound particles is smaller than the size of colloidal particles.

In another aspect, the invention provides a method of making solid metal compound coated colloidal particles comprising:

providing a solution comprising colloidal particles;
providing a soluble metal compound precursor;
providing a base;
adding the soluble metal compound precursor and the base independently to the solution comprising colloidal particles; and
forming the solid metal compound coated colloidal particles;
wherein the soluble metal compound precursor reacting with the base solution and turning into solid metal compounds; and the solid metal compounds are coated onto colloidal particle surfaces through bonding.

In yet another aspect, the invention provides a composition for chemical-mechanical polishing comprising:

solid metal compound coated colloidal particles; and
an oxidizer;
wherein the solid metal compound coated colloidal particles comprising metal compounds having size ranging from 0.01 to 10 nm coated on surfaces of colloidal particles having size ranging from 10 to 1000 nm; the size of the metal compounds is smaller than the size of colloidal particles; and metal compounds are solely coated on the surfaces of colloidal particles through bonding.

In yet another aspect, the invention provides a method of chemical mechanical polishing, comprising the steps of:

a) providing a semiconductor substrate;

b) providing a polishing pad;

c) providing a composition comprising solid metal compound coated colloidal particles; and an oxidizer;
wherein
the solid metal compound coated colloidal particles comprising metal compounds having size ranging from 0.01 to 10 nm coated on surfaces of colloidal particles having size ranging from 10 to 1000 nm; the size of the metal compounds is smaller than the size of colloidal particles; and metal compounds are solely coated on the surfaces of colloidal particles through bonding;
the colloidal particles are particles selected from silica particles, lattice doped silica particles, germania particles, alumina particles, lattice doped alumina particles, titania particles, zirconium oxide particles, ceria particles, organic polymeric particles, and combinations thereof;
the metal compounds are compounds selected from Fe compounds, Cu compounds, Ag compounds, Cr compounds, Mn compounds, Co compounds, Ni compounds, Ga compounds, and combinations thereof;

d) contacting surface of the semiconductor substrate with the polishing pad and the composition; and

e) polishing the surface of the semiconductor substrate;
wherein the surface of the semiconductor substrate containing a metal and at least one other material; and ratio of removal rate of metal to removal rate of the at least one other material is equal or greater than 1.

The chemical-mechanical polishing composition preferably further comprises an abrasive, and optionally a corrosion inhibitor.

The colloidal particles are preferably particles selected from silica particles, lattice doped silica particles, germania particles, alumina particles, lattice doped alumina particles, titania particles, zirconium oxide particles, ceria particles, organic polymeric particles, and combinations thereof; the metal compounds are preferably compounds selected from Fe compounds, Cu compounds, Ag compounds, Cr compounds, Mn compounds, Co compounds, Ni compounds, Ga compounds, and combinations thereof; and/or the base is preferably selected from the group consisting of KOH, $NH_4OH$, NaOH, $KHCO_3$, $K_2CO_3$, quaternary ammonium hydroxides, organic amines, phosphonium hydroxides, N-heterocyclic compounds, and combinations thereof.

The weight % ratio of the metal compound precursor to the colloidal particles preferably ranges from 0.001 to 3; and molar ratio of the base to the metal compound precursor is preferably higher than 2.5.

Further aspects of the invention include:

#1. Particulates comprising :

solid metal compound coated colloidal particles formed by bonding metal compound particles on surfaces of colloidal particles; and

spaces among solid metal compound coated colloidal particles are free of the metal compound particles;

wherein

size of the metal compound particles ranging from 0.01-10 nm;

size of the colloidal particles ranging from 10-1000 nm; and

the size of the metal compound particles is smaller than the size of colloidal particles.

#2. The particulates of #1, wherein the colloidal particles are particles selected from silica particles, lattice doped silica particles, germania particles, alumina particles, lattice doped alumina particles, titania particles, zirconium oxide particles, ceria particles, organic polymeric particles, and combinations thereof.

#3. The particulates of #1, wherein the metal compounds are compounds selected from Fe compounds, Cu compounds, Ag compounds, Cr compounds, Mn compounds, Co compounds, Ni compounds, Ga compounds, and combinations thereof.

#4. The particulates of #1, wherein the colloidal particles are silica particles; the metal compounds are iron compounds; and the metal compounds coated colloidal particles are iron coated silica particles.

#5. A method of making solid metal compound coated colloidal particles comprising:

providing a solution comprising colloidal particles;

providing a soluble metal compound precursor;

providing a base;

adding the soluble metal compound precursor and the base to the solution comprising colloidal particles; and

forming the solid metal compound coated colloidal particles ;

wherein the soluble metal compound precursor reacting with the base solution and turning into solid metal compounds; and the solid metal compounds are coated onto colloidal particle surfaces through bonding.

#6. The method of making solid metal compound coated colloidal particles of #5, wherein the colloidal particles are particles selected from silica particles, lattice doped silica particles, germania particles, alumina particles, lattice doped alumina particles, titania particles, zirconium oxide particles, ceria particles, organic polymeric particles, and combinations thereof; the metal compounds are compounds selected from Fe compounds, Cu compounds, Ag compounds, Cr compounds, Mn compounds, Co compounds, Ni compounds, Ga compounds, and combinations thereof; and the base is selected from the group consisting of KOH, $NH_4OH$, $KHCO_3$, $K_2CO_3$, quaternary ammonium hydroxides, organic amines, phosphonium hydroxides, N-heterocyclic compounds, and combinations thereof.

#7. The method of making solid metal compound coated colloidal particles of #5, wherein the colloidal particles are silica particles; the metal compounds are iron compounds; the base is KOH or NaOH; and the metal compounds coated colloidal particles are iron coated silica particles.

#8. The method of making solid metal compound coated colloidal particles of #5, wherein weight % ratio of the metal compound precursor to the colloidal particles ranges from 0.001 to 3; and molar ratio of the base to the metal compound precursor is higher than 2.5.

#9. The method of making solid metal compound coated colloidal particles of #5, further comprising a step of removing excess ions comprising metal ions from the solution containing the solid metal compound coated colloidal particles.

#10. The method of making solid metal compound coated colloidal particles of #9, wherein the step of removing excess ions is through ultrafiltration process.

#11. The method of making solid metal compound coated colloidal particles of #10, wherein the excess metal ions in the solution are less than 2 ppm, and the concentration of the solution containing the solid metal compound coated colloidal particles ranging from 0.01 to 50 wt%.

#12. The method of making solid metal compound coated colloidal particles of #10, further comprising a step of heating the solution containing the solid metal compound coated colloidal particles at a temperature ranging from 40°C to 100 °C for 0.5 to 72 hours.

#13. The method of making solid metal compound coated colloidal particles of #5, wherein the colloidal particles having size ranging from 10 to 1000 nm, the solid metal compounds having size ranging from 0.01 to 10 nm, and the size of the metal compounds is smaller than the size of the colloidal particles.

#14. A composition for chemical-mechanical polishing comprising:

solid metal compound coated colloidal particles; and
an oxidizer;
wherein the solid metal compound coated colloidal particles comprising metal compounds having size ranging from 0.01 to 10 nm coated on surfaces of colloidal particles having size ranging from 10 to 1000 nm; the size of the metal compounds is smaller than the size of colloidal particles; and metal compounds are solely coated on the surfaces of colloidal particles through bonding.

#15. The composition of #14, wherein the colloidal particles are particles selected from silica particles, lattice doped silica particles, germania particles, alumina particles, lattice doped alumina particles, titania particles, zirconium oxide particles, ceria particles, organic polymeric particles, and combinations thereof; the metal compounds are compounds selected from Fe compounds, Cu compounds, Ag compounds, Cr compounds, Mn compounds, Co compounds, Ni compounds, Ga compounds, and combinations thereof.

#16. The composition of #14, wherein the colloidal particles are silica particles; the metal compounds are iron compounds; and the metal compounds coated colloidal particles are iron coated silica particles.

#17. The composition of #16, wherein the composition is an aqueous composition and the solid metal compound coated colloidal particles are dispersed uniformly in an aqueous solvent.

#18. The composition of #17, further comprising an abrasive, and optionally a corrosion inhibitor.

#19. A method of chemical mechanical polishing, comprising the steps of:

a) providing a semiconductor substrate;

b) providing a polishing pad;

c) providing a composition comprising solid metal compound coated colloidal particles; and an oxidizer; wherein
the solid metal compound coated colloidal particles comprising metal compounds having size ranging from 0.01 to 10 nm coated on surfaces of colloidal particles having size ranging from 10 to 1000 nm; the size of the metal compounds is smaller than the size of colloidal particles; and metal compounds are solely coated on the surfaces of colloidal particles through bonding;
the colloidal particles are particles selected from silica particles, lattice doped silica particles, germania particles, alumina particles, lattice doped alumina particles, titania particles, zirconium oxide particles, ceria particles, organic polymeric particles, and combinations thereof;
the metal compounds are compounds selected from Fe compounds, Cu compounds, Ag compounds, Cr compounds, Mn compounds, Co compounds, Ni compounds, Ga compounds, and combinations thereof;

c) contacting surface of the semiconductor substrate with the polishing pad and the composition; and

d) polishing the surface of the semiconductor substrate;
wherein the surface of the semiconductor substrate containing a metal and at
least one other material; and ratio of removal rate of metal to removal rate of the at least one other material is equal or greater than 1.

#20. The method of #19, wherein the composition is an aqueous composition and the solid metal compound coated colloidal particles are dispersed uniformly in an aqueous solvent.

#21. The method of #20, wherein the metal compounds coated colloidal particles are iron coated silica particles; the metal is tungsten and the at least one other material is a dielectric material; and tungsten removal profile WIWNU% is less than 4.

#22. The method of #19, wherein the composition further comprising an abrasive, and optionally a corrosion inhibitor.

In a further aspect, the invention relates to a system of selective chemical mechanical polishing comprising:

a) a polishing pad;

b) a chemical mechanical polishing (CMP) composition as described herein.

Preferably, the system further comprises a semiconductor substrate as described herein.
Aspects described in connection with one aspect of the invention can be used in combination with any other aspect of the invention.
The term "coated" as used herein includes a situation where material covers a surface partially but not completely.

BRIEF DESCRIPTION OF SEVERAL VIEWS OF THE DRAWINGS

In the accompanying drawings forming a material part of this description, there are shown:

FIGURE 1 depicts the transmission electron microscopy (TEM) images of colloidal silica particles.

FIGURE 2 depicts the transmission electron microscopy (TEM) images of iron compound coated colloidal silica particles.

FIGURE 3 depicts energy dispersive spectra (EDS) of iron compound coated silica particle.

FIGURE 4 depicts the tungsten removal profile using the CMP slurry containing the iron compound coated silica particle.

DETAILED DESCRIPTION OF THE INVENTION

The present invention discloses metal compound coated colloidal particles, the process of making the metal compound coated colloidal particles, and the use of the metal compound coated colloidal particles in chemical mechanical polishing (CMP) applications.

A colloidal particle solution (also referred to herein as a "suspension") containing 0.01 to 50 wt% of colloidal particles is preferably prepared. The remaining is preferably solvent, more preferably an aqueous solvent, such as distilled water, and deionized (DI) water. The colloidal particles include but are not limited to silica, lattice doped silica, alumina, lattice doped alumina, zirconium oxide, ceria, organic polymeric particles, and combinations thereof.

The organic polymeric particles include but are not limited to carboxylic acid polymers such as those derived from monomers like acrylic acid, oligomeric acrylic acid, methacrylic acid, crotonic acid and vinyl acetic acid. Molecular weight of these polymers may be from 20000 to 10000000.

The colloidal particles can have various sizes. The size of colloidal particles preferably ranges between 10-1000 nm, more preferably 10-500 nm, most preferably 15-250 nm for CMP application. The colloidal particles can have various kinds of shapes, such as spherical, cocoon, cubic, rectangular, aggregate, etc. "Size" as used herein is preferably mean particle size as measured by electron microscopy.

Soluble metal compound precursors include but are not limited to compounds of iron Fe, copper Cu, silver Ag, manganese Mn, chromium Cr, gallium Ga, cobalt Co, nickel Ni, and combinations thereof.

The metal compound precursor can be metal ion precursors, including but not limited to the salt of metal ion with nitrate, sulfate, chloride, oxide and combinations thereof. Iron compound precursors include but are not limited to ferric nitrate, ferric sulfate, ferric oxide, ferric chloride and combinations thereof.

Soluble metal compound precursor is preferably added to the colloidal particle solution. The weight ratio of metal compound precursor to colloidal particles in the solution is preferably -0.001 to 3. As an example, 1.0 gram of metal compound can be added into a colloidal particle solution that contains 100 gram of colloidal particles which gives the weight ratio of 0.01 between the metal compound precursor and colloidal particles in the solution.

A base solution is preferably added to the colloidal particle solution. Bases include but are not limited to KOH, $NH_4OH$, NaOH, $KHCO_3$, $K_2CO_3$, quaternary ammonium hydroxides, organic amines, phosphonium hydroxides, N-heterocyclic compounds, and combinations thereof.

The alkyl groups of quaternary ammonium hydroxides can be the same, such as methyl groups, ethyl groups, or can be different, such as dibutyl-dimethyl-ammonium hydroxide. Examples include but are not limited to tetramethylammonium hydroxide (TMAH), tetraethylammonium hydroxide (TEAH), tetrabutylammonium hydroxide (TBAH), tetraalkylammonium hydroxide (TAAH). The quaternary ammonium hydroxides may also include aryl groups as well.

The organic amines include but are not limited to methylamine, dimethylamine, trimethylamine as well as alcohol amines such as ethanol amine.

Examples of phosphonium hydroxides include, but are not limited to tetrabutylphosphonium hydroxide and tetramethylphosphonium hydroxides. Examples of N-heterocyclic compounds include, but are not limited to compounds containing pyridine, imidazole, histidine groups.

The soluble metal compound precursor and the base solution can be added to the colloidal particle solution separately, in sequence, or at the same time. Preferably the metal compound precursor and base do not contact one another while they are not in contact with the colloidal particles. The molar ratio of base to soluble metal compound precursor should preferably be higher than 2.5.

Metal compound precursors react with the base, to turn into solid metal compound. The soluble metal compound precursor can be ~100% converted into solid metal compounds through the reaction. The solid metal compound is preferably a metal oxide, a metal hydroxide or a mixed metal oxide/hydroxide.

The solid metal compounds are then deposited or coated onto colloidal particle surfaces through bonding (such as chemical bonding e.g. co-ordination or covalent bonding) to obtain metal compound coated colloidal particles. The metal compound coated colloidal particles have solid metal compounds immobilized/bonded on the surfaces of colloidal particles. Preferably, the solid metal compound is itself in the form of particles. Preferably, no free particles of solid metal compound are present in the composition of the invention i.e. all particles of solid metal compound present are coated on the colloidal particles. This requirement is also expressed herein as "the metal compounds are solely coated on the surfaces of colloidal particles through bonding" and "spaces among solid metal compound coated colloidal particles are free of the metal compound particles". Preferably the metal compound is not present in solution either, or is present in very low concentration, as explained in more detail below.

Solid metal compounds include but are not limited to Fe compounds, Cu compounds, Ag compounds, Cr compounds, Mn compounds, Co compounds, Ni compounds, Ga compounds.

According to Derjaguin and Landau, Verwey and Overbeek (DLVO) theory, the energy barrier between charged colloidal particles will become smaller upon increased ionic strength. During the deposition or coating process, excess ions result from the soluble metal compound precursor increase ionic strength of the solution. If these excess ions stay in the solution, the solution is not stable and will show some settlement slowly over the time. The higher loading density (weight ratio of ions to colloidal particles) of ion, the more critical the stability is.

Excess ions in the metal compound coated colloidal particle solution are preferably removed by ultrafiltration process to obtain the stable metal compound coated colloidal particle solution. Ultrafiltration is an in-line technique. The process removes anything whose size is smaller than the cut-off size of the filter membrane.

Soluble ions (for example, metal ions, $NO_3^-$ from ferric nitrate, $K^+$ from KOH) with sizes smaller than the cut-off size of the filter membrane are easily removed from the solution. During the ultrafiltration process, the metal compound coated colloidal particles which are much bigger than filter cut-off size remain in the solution without any aggregation.

The metal ions left in the solution after the ultrafiltration process can be measured by centrifugation process. The supernatant of the result solution after centrifugation should contain less than 2 ppm, preferred less than 1 ppm metal ions. Thus, the metal compound coated colloidal particle solution is preferably substantially free of excess metal ions after the ultrafiltration process.

Furthermore, in addition to removal of excess ions in the metal compound coated colloidal particle solution, the ultrafiltration also serves function of concentrating the solution.

After the amount of soluble ions is lowered to the desired level (monitored by conductivity meter), the amount of solids (the metal compound coated colloidal particles) can be increased by reducing the amount of the compensated distilled water being added into the solution that contains metal compound coated colloidal particles. Thus, the solution is more concentrated.

The concentrated solution allows the production of more concentrated CMP slurry products. This is important since the cost of ownership can be greatly reduced.

The ultrafiltrated solution can be heated, for example at a temperature ranging from 40°C to 100 °C for 0.5 to 72 hours.

The invented process herein may yield unique results i.e. the solid metal compounds are substantially coated uniformly on the surface of colloidal particles. The solid content of such solid metal compound coated colloidal particle solutions preferably ranges from 0.1 wt% to 40 wt%.

The size of the solid metal compound particles coated on the colloidal particle surfaces preferably ranges from 0.01 to 10 nm with a standard deviation of size less than 20%. The solid metal compounds coated on the colloidal particle surfaces can be in amorphous form, crystalline form, and combinations thereof.

The metal compound coated colloidal particles thus obtained have an important role in slurries for chemical mechanical polishing (CMP) applications.

A CMP slurry usually comprises abrasive, corrosion inhibitor, catalyst and oxidizer.

The catalyst could be in the soluble form or solid state form. The metal compound coated colloidal particles described in present invention are the solid state form of catalysts.

Any suitable abrasive including but not limited to silica, alumina, titania, ceria, zirconia can be used in the CMP slurry. The amount of abrasive in the slurry preferably ranges from 0 to 25 wt%.

Suitable corrosion inhibitors include but are not limited to polyethyleneamine; and other organic amine oligomers, and molecules. The amount of corrosion inhibitor in the slurry preferably ranges from 0.0001 wt% to 2 wt%.

Any suitable oxidizer including but not limited to $H_2O_2$ and other peroxy compounds can be used in the CMP slurry. The amount of oxidizer in the slurry preferably ranges from 0.1 wt % to 10 wt%.

The metal compound coated colloidal particles are then suitably used as the solid state catalyst in a CMP polishing composition. The amount of the solid catalyst in the slurry preferably ranges from 0.01 wt% to 10 wt%.

The metal compound coated colloidal particles can be used as both the solid state catalyst as well as the abrasive in a CMP polishing compositions.

For a CMP slurry, removal rate (RR) (A /min) and Within Wafer non-uniformity %(WIWNU%) are used to measure the performance of the slurry. An increased RR and reduced WIWNU% are indications of better performance of a slurry.

Removal Rate (RR) is the average amount of material removed in a given time, typically calculated over a great number of points:

$$RR = \frac{\sum (\text{Pre-polish thickness-Post-polish thickness}) / \# \text{ of points}}{\text{Time of polishing}}$$

Suitable surface uniformity (typically measured using known wafer profiling techniques) is reflected by within-wafer nonuniformity, or WIWNU%. It is the standard deviation of the removal rate of material from the wafer expressed in percent. Lower values typically reflect better process control.

WIWNU% is calculated using the following equation:

$$\text{WIWNU\%} = (\text{pre-polishing W film thickness} - \text{post-polishing W film thickness}) / \text{mean of total W film thickness X } 100\%$$

When the metal compound coated particles from embodiments of the present invention are used in a CMP slurry, unexpected performances have been observed. Removal rate (RR) (A /min) is increased, while reduced Within Wafer non-uniformity %(WIWNU%) can be achieved. RR can be tunable ranging 500 - 6000 Å /min, and WIWNU% is less than about 4%, preferably, 3%, and most preferably 2%.

## Working Examples

Iron compound coated colloidal particles, and CMP slurry using the iron compound coated colloidal particles as catalysts have been made in the working examples. The performance of the CMP slurry was measured.

## Iron compound coated colloidal silica particles

In this example, iron compound coated colloidal silica particles were made by the process described below.

Iron precursor (soluble iron compound, such as ferric nitrate, ferric sulfate or a combination); colloidal silica; and KOH or ammonium hydroxide; were chosen as the soluble metal precursor, the colloidal particles and the base, respectively.

2.87 wt% colloidal silica solution was used. The size of the colloidal silica was around 40-50 nm.

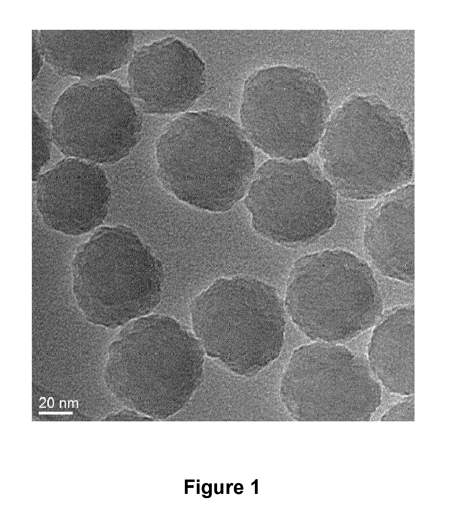

The transmission electron microscopy (TEM) images of colloidal silica particles were shown in Figure 1. The colloidal silica particles were fairly spherical.

431 ppm iron precursor prepared using ferric nitrate was added into 2.87 wt% colloidal silica solution. The solution was stirred for 5 min.

The base solution KOH or ammonium hydroxide) was added into the above solution under stirring. The molar ratio of base to soluble metal compound precursor was 3.5 when KOH was used as the base; and was 5 when ammonium hydroxide was used as the base.

The solution was stirred for 10 min.

The resultant solution was sent to a ultrafiltration process to remove excess ions. Conductivity was monitored during the ultrafiltration process. The resulted solution was ultrafiltered until conductivity was lowered to certain level, in this example: 100 $\mu$S/cm. The resulted colloidal solution had a neutral pH. The solution was stable over a wide pH range. The pH of such iron compound coated colloidal silica solution can be adjusted as needed.

The wt% of the solid content in the solution could be increased by decreasing the flow of compensating DIW into the solution. For example 14 wt% was achieved.

The resulting solution was transferred into a reactor. The temperature for the reactor was increased to 80° C. The solution was kept stirred at this temperature for 2 hours.

A soluble iron test was conducted next to check the amount of soluble iron left in the solution. The solution was centrifuged at 13,500 RPM for 1 hour. The supernatant was obtained. Full digestion of supernatant (by mixture of $H_2O_2$ and sulfuric acid) was conducted by Inductively coupled plasma atomic emission spectroscopy-(ICP-AES) measurement of iron level. The iron level obtained was less than 1 ppm, thus confirming that there was substantially no soluble iron left in the solution.

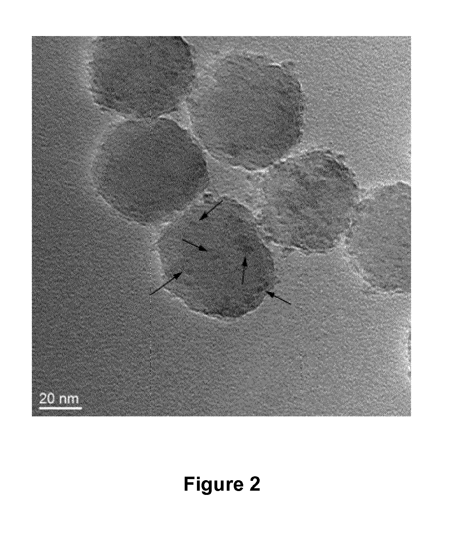

Figure 2 depicts transmission electron microscopy (TEM) images of the iron compound coated silica particles prepared by the process as disclosed.

The solid iron compound on the silica surface was amorphous, having a size of 1-10 nm with the standard deviation of size less than 20%.

The solution can be further heated under 100 °C for 1-24 hours to have iron compounds in crystalline form, and combinations of amorphous and crystalline.

More specifically, Figure 2 depicts particulates having the following features: solid iron compound particles (indicated by arrows) having a size around 2-3 nm were uniformly coated on the surfaces of colloidal silica particles having a size of -40-50 nm. All solid iron compound particles were solely coated (bonded) to the surfaces of colloidal silica particles; unbonded iron compound particles were not present. Iron compound particles were not presented in the spaces among iron compound coated colloidal silica particles. Both solid iron compound particles and colloidal silica particles were fairly spherical.

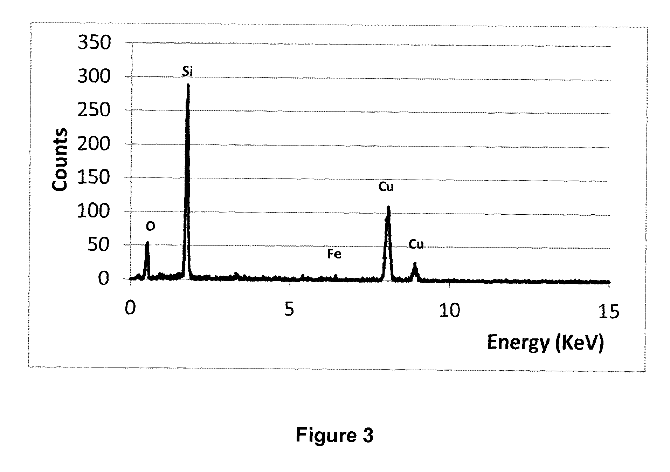

The energy dispersive spectra (EDS) from the prepared iron compound coated silica particles are shown in Figure 3. EDS confirmed the existence of iron (copper peak came from the TEM grid).

It is understood that the amount of soluble metal precursor, the colloidal silica particles and the base used depended on the desired loading of catalyst, metal compounds or desired coating density of metal compounds.

**CMP slurry using iron compound coated silica particles**

The iron compound coated colloidal silica particles were used as solid catalyst in a CMP slurry for polishing wafer or semiconductor substrates containing tungsten (W) and TEOS.

Polishing performance of the slurry containing the iron compound coated silica particles was measured.

As shown in Table 1, the new solid catalyst made with the process disclosed in present invention (using ferric nitrate and KOH) provided high W RR and low TEOS RR, which in turn resulted in a high selectivity of W:TEOS. The experiment was repeated to give the two sets of results in Table 1.

Table 1. Polishing performance of the slurry contains solid catalyst

| Slurry | W RR (Å/min) | WIWNU% | TEOS RR(Å/min) | Selectivity (W/TEOS) |
|---|---|---|---|---|
| with solid catalyst made by process of present invention | 4989 | 1.54 | 67 | 74.5 |
| | 4833 | 1.73 | 71 | 68.1 |

Most importantly, with the use of new solid state catalysts in W CMP polishing composition, the W removal profile was unexpected uniform across the whole wafer.

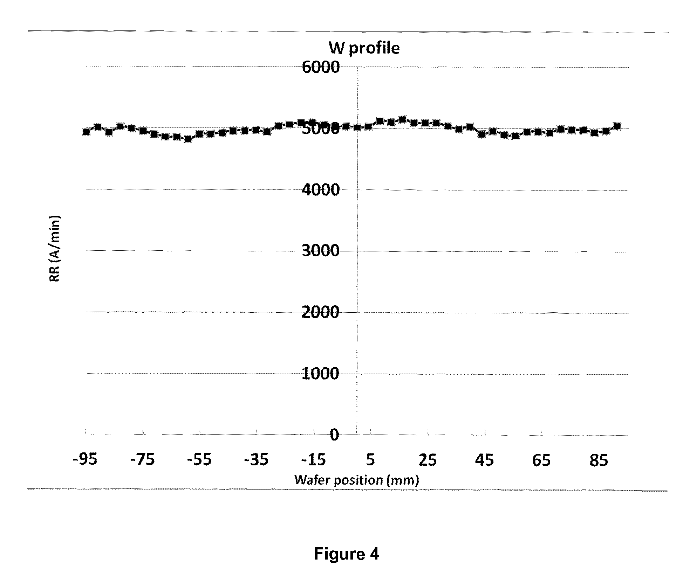

As illustrated in Figure 4, with the new catalyst, the W removal profile offered a very flat curve; indicating the W removal profile was very uniform. Usually, the edges of W profile polished with other W slurries are dropped much lower than the center. The WIWNU% across the wafer was unexpectedly reduced to around ~1.5-1.7%. A typical WIWNU% across the wafer is greater than 4.0%. WIWNU% was greatly improved.

A stable, well-dispersed solution is very critical for CMP slurry. A unstable or separated CMP slurry often contains a lot of aggregates or large particles, which cause defects on the film polished.

The solid metal compound coated colloidal particles made with present invention sustain a dispersed state, which means the solution containing the solid metal compound coated colloidal particles is a uniform solution, and does not separate into layers. The CMP slurry comprising the solid metal compound coated colloidal particles directly combined with other additives gave unexpected performance.

The embodiments and working examples of present invention listed above are exemplary of numerous embodiments and working examples that may be made of the present invention. It is contemplated that numerous other configurations of the process may be used, and the materials used in the process may be elected from numerous materials other than those specifically disclosed.

**Claims**

1. Particulates comprising:

   solid metal compound coated colloidal particles formed by bonding metal compound particles on surfaces of colloidal particles, and optionally further comprising solvent; wherein
   spaces among solid metal compound coated colloidal particles are free of the metal compound particles; and wherein
   the size of the metal compound particles is in the range of 0.01-10 nm;
   the size of the colloidal particles is in the range of 10-1000 nm; and

the size of the metal compound particles is smaller than the size of colloidal particles.

2. The particulates of Claim 1, wherein the colloidal particles are particles selected from silica particles, lattice doped silica particles, germania particles, alumina particles, lattice doped alumina particles, titania particles, zirconium oxide particles, ceria particles, organic polymeric particles, and combinations thereof; and/or the metal compounds are compounds selected from selected from Fe compounds, Cu compounds, Ag compounds, Cr compounds, Mn compounds, Co compounds, Ni compounds, Ga compounds, and combinations thereof.

3. The particulates of Claim 1, wherein the colloidal particles are silica particles; the metal compounds are iron compounds; and the metal compound coated colloidal particles are iron compound coated silica particles.

4. A method of making solid metal compound coated colloidal particles optionally being particulates as claimed in any one of the preceding claims comprising:

    providing colloidal particles;
    providing a soluble metal compound precursor;
    providing a base;
    combining the soluble metal compound precursor, the base and the colloidal particles in a solution; and
    forming the solid metal compound coated colloidal particles;
    wherein the soluble metal compound precursor reacts with the base solution to form solid metal compound; and the solid metal compound is coated onto the surfaces of the colloidal particles through bonding.

5. The method of making solid metal compound coated colloidal particles of Claim 4, wherein the soluble metal compound precursor is selected from a nitrate salt, a sulfate salt, a chloride salt, an oxide and combinations thereof and/or the base is selected from the group consisting of $KOH$, $NH_4OH$, $NaOH$, $KHCO_3$, $K_2CO_3$, quaternary ammonium hydroxides, organic amines, phosphonium hydroxides, N-heterocyclic compounds, and combinations thereof.

6. The method of making solid metal compound coated colloidal particles of Claim 4, wherein the colloidal particles are silica particles; the metal compounds are iron compounds; the base is $KOH$ or $NH_4OH$; and the metal compounds coated colloidal particles are iron compound coated silica particles.

7. The method of making solid metal compound coated colloidal particles of any one of Claims 4 to 6, wherein the weight % ratio of the metal compound precursor to the colloidal particles is in the range of 0.001 to 3; and/or the molar ratio of the base to the metal compound precursor is higher than 2.5.

8. The method of making solid metal compound coated colloidal particles of any one of Claims 4 to 7, further comprising a step of removing excess ions comprising metal ions from the solution containing the solid metal compound coated colloidal particles, optionally through an ultrafiltration process.

9. The method of making solid metal compound coated colloidal particles of any one of Claims 4 to 8, wherein the method further comprises a step of heating the solution containing the solid metal compound coated colloidal particles, preferably at a temperature in the range of 40°C to 100 °C and/or for 0.5 to 72 hours.

10. The method of making solid metal compound coated colloidal particles of Claim 8 or Claim 9, wherein the remaining concentration of excess metal ions in the solution is less than 2 ppm, and/or the concentration of the solution containing the solid metal compound coated colloidal particles is in the range of 0.01 to 50 wt%.

11. A composition for chemical-mechanical polishing comprising:

    solid metal compound coated colloidal particles optionally being particulates as claimed in any one of Claims 1 to 3; and
    an oxidizer;
    wherein the solid metal compound coated colloidal particles comprise metal compounds having size in the range of 0.01 to 10 nm coated on surfaces of colloidal particles having size in the range of 10 to 1000 nm; the size of the metal compounds is smaller than the size of colloidal particles; and the metal compounds are solely coated on the surfaces of colloidal particles through bonding.

12. The composition of Claim 11, wherein the composition is an aqueous composition and the solid metal compound coated colloidal particles are dispersed uniformly in an aqueous solvent.

13. The composition of Claim 11 or Claim 12, further comprising an abrasive, and optionally a corrosion inhibitor.

14. A method of chemical mechanical polishing, comprising the steps of:

a) providing a semiconductor substrate;
b) providing a polishing pad;
c) providing a composition as claimed in any one of Claims 11 to 13;
d) contacting the surface of the semiconductor substrate with the polishing pad and the composition; and
e) polishing the surface of the semiconductor substrate;

wherein the surface of the semiconductor substrate contains a metal and at least one other material; and ratio of removal rate of metal to removal rate of the at least one other material is equal or greater than 1.

15. The method of Claim 14, wherein the metal compound coated colloidal particles are iron compound coated silica particles; the metal is tungsten and the at least one other material is a dielectric material; and tungsten removal profile WIWNU% is less than 4.

**Figure 1**

**Figure 2**

**Figure 3**

Figure 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4478742 A
- US 20130068995 A

**Non-patent literature cited in the description**

- *J. Colloid & Inter. Sci.,* 2010, vol. 349, 402-407
- *J. Colloid & Inter. Sci.,* 2005, vol. 282, 11-19
- *Tribology,* 2010, vol. 30 (3), 268-272